Europäisches Patentamt

European Patent Office

Office européen des brevets

(19)

(11) Publication number: **0 053 654**

A2

(12) **EUROPEAN PATENT APPLICATION**

(21) Application number: 81106695.0

(22) Date of filing: 28.08.81

(51) Int. Cl.³: **H 01 L 27/06**
**H 01 L 29/92, H 01 L 21/00**
**G 11 C 11/24, G 11 C 11/34**

(30) Priority: 04.12.80 US 212784

(43) Date of publication of application:
16.06.82 Bulletin 82/24

(84) Designated Contracting States:
DE FR GB IT

(71) Applicant: Rockwell International Corporation
2230 East Imperial Highway
El Segundo, California 90245(US)

(72) Inventor: Custode, Frank Zuchov
4532 Palomino Road
Norco Calif. 91760(US)

(72) Inventor: Tam, Matthias Lapkay
853 Ridge Crest Street
Monterey Park Calif. 91754(US)

(74) Representative: Wagner, Karl H., Dipl.-Ing.
P.O. Box 22 02 46 Gewuerzmuehlstrasse 5
D-8000 München 22(DE)

(54) **High capacitance single transistor memory cell suitable for high density RAM applications.**

(57) The invention comprises a high capacity memory cell including a gating transistor and a novel capacitance. A silicon substrate may be used or a sapphire substrate with a silicon layer thereon. For forming the capacitor, a doped polysilicon layer is disposed adjacent the silicon for forming a junction therein with a patterned nitride adjacent the doped polysilicon layer and a further polysilicon layer adjacent the nitride layer such that the capacitor so formed has a capacity four times as great as a conventional silicon oxide and poly capacitor and is increased to six times as great when the junction capacity and nitride capacity are added, thus providing a very substantial savings in real estate on the chip. A field effect transistor is added to the capacitor by silicon oxide covered by polysilicon with doping extending between the capacitor and the gate region to connect electrically with the junction while providing the drain, the source being a doped region on the other side of the gate. The method of forming capacitance memory cells is unique in that each gate is formed as a layer of gate oxide with a layer of doped polysilicon thereover, doped substrate regions are formed on opposite sides of the gate to comprise a transistor with the doped substrate region on one side of the gate being in electrical connection with the junction doped region on said one side of the gate, which junction lies under a layer of doped polysilicon covered by a layer of nitride in turn covered by a second layer of doped polysilicon to comprise the capacitor.

FIG. 2

## HIGH CAPACITANCE SINGLE TRANSISTOR MEMORY
## CELL SUITABLE FOR HIGH DENSITY RAM APPLICATIONS

### Field of the Invention

The invention relates to a novel structure and method for forming a high capacitance and a single transistor capable of use as a memory cell for high density RAM applications.

### Background Art

The closest known prior art is U. S. Patent 4,231,651, issued October 28, 1980, to Frank Custode et al, which patent shows one method which is modifiable in accordance with the present teachings to manufacture the memory cell of the present invention. However, the prior art does not teach the use of nitride layers in a finished device but only in the form of masks; and no first and second polysilicon layers are employed and no discrete capacitors are formed.

### Brief Description of the Invention

The invention comprises a high capacity memory cell including a gating transistor. The silicon substrate may be used or a sapphire substrate with a silicon layer thereon. For forming a novel capacitor, a doped polysilicon layer is disposed adjacent the silicon for forming a junction therein with a patterned nitride layer adjacent the doped polysilicon layer and a further polysilicon layer adjacent the nitride layer such that the capacitor so formed has a capacity four times as great as a conventional silicon oxide and poly capacitor and is increased to six times as great when the junction capacity and nitride capacity are added, thus providing a very substantial savings in real estate on the chip. A field effect transistor is added to the capacitor by silicon oxide covered by polysilicon with doping extending between the capacitor and the gate region to connect electrically with the junction while providing the drain, the source being a doped region on the other side of the gate. The method of forming capacitance memory cells is unique in that each gate is formed as a layer of gate oxide with a layer of doped polysilicon thereover, doped substrate regions are formed on opposite sides of the gate to comprise a transistor with the doped substrate region on one side of the gate being in electrical connection with the junction doped region on said one side of the gate, which junction lies under a layer of doped polysilicon covered by a layer of nitride, in turn covered by a second layer of doped polysilicon to comprise the capacitor.

Brief Description of the Drawings

FIGURE 1 is a drawing of a conventional prior art memory cell structure;

FIGURE 2 is a drawing of the construction of a memory cell in accordance with the present invention;

FIGURE 3 is the electrical circuit for the structure of FIG. 1;

FIGURE 4 is the electrical circuit equivalent for the structure of FIG. 2;

FIGURE 5 shows the construction of the cell of FIG. 2 on sapphire;

FIGURE 6 is a view of a mask useful in a suitable process for forming the cell of FIG. 2;

FIGURE 7 is a view in section of the structure formed on a substrate by the use of the mask of FIG. 6;

FIGURE 8 shows the structure of FIG. 7 with field oxide doping implantation in the regions where the field oxide will be formed;

FIGURE 9 shows the formation of the field oxide;

FIGURE 10 shows the use of photoresist to define an opening to the substrate for implanting;

FIGURE 11 shows the structure following the implanting;

FIGURE 12 shows the structure of FIG. 11 covered by the doped polysilicon layer and a thin nitride layer:

FIGURE 13 shows a gate capacitor mask;

FIGURE 14 shows the structure of FIG. 12 with resist added for the gate and capacitor regions;

FIGURE 15 shows the polysilicon and nitride etched away in the unmasked regions and, additionally the doping for the transistor source and capacitor junction;

FIGURE 16 shows the structure of FIG. 15 with the resist removed;

FIGURE 17 shows the second doped poly II layer applied over the entire active region;

FIGURE 18 depicts capacitor mask -2;

FIGURE 19 shows the poly II removed except over the capacitive region;

FIGURE 20 shows the nitride layer removed from the gate;

FIGURE 21 shows the entire active area covered with a layer of phosphorus doped glass;

FIGURE 22 shows contact openings to the source, gate, and capacitor; and,

FIGURE 23 shows the conductors making contact with these opened regions.

Description of a Preferred Embodiment

The present invention provides a new technique which enables the reduction in area for a memory cell without any penalties in storage capacitance. Additionally, this invention is fully compatible with the existing processing practices and provides a novel capacitor structure.

During recent years the density of RAMs has been increasing rapidly. At the present time, the single transistor cell has found widespread use in the fabrication of dynamic memories. However, limitations exist in the prior art reducing the size of such cells because of the requirements for sufficient storage capacitance.
Furthermore, east of processing and compatibility with existing
technology have limited the advancement of all designs and the fabricating
of larger RAMs.

In the subject invention, doped polysilicon makes contact with
single crystal silicon to make a "buried" structure which enables the
diffusion of dopant from the polysilicon source into the bulk silicon
to form a junction. At the same time, this first layer of polysilicon
forms the transfer gate of the memory cell. Nitride is left on top of
the polysilicon once it has been patterned. This thin layer of nitride
represents the dielectric material that will comprise the capacitor
insulator between the first polysilicon layer and the second polysilicon
layer.

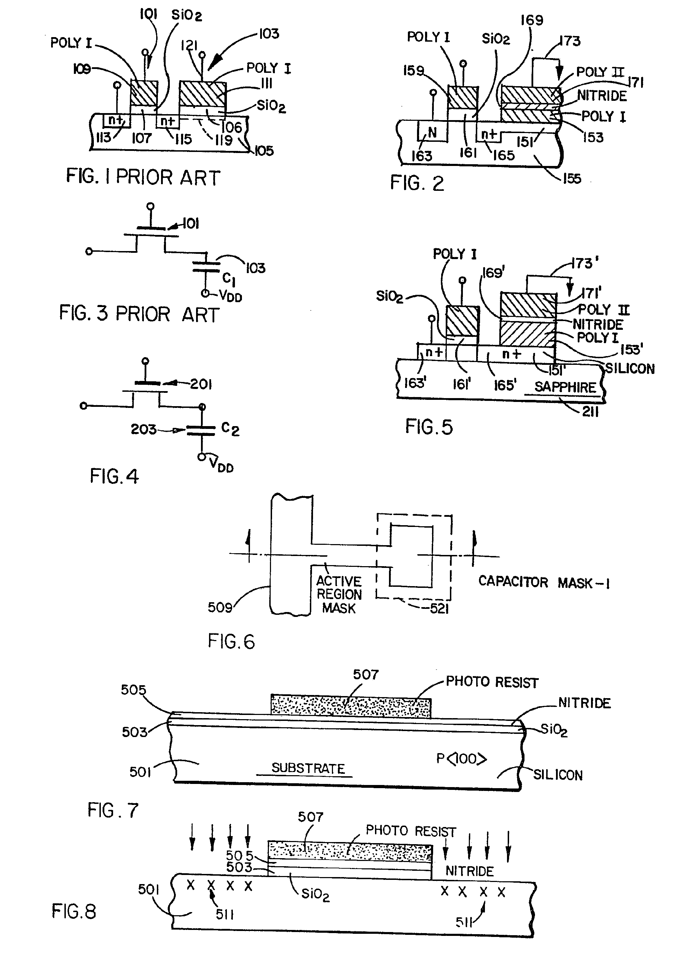

Reference may be had to FIG. 1 wherein the prior art conventional
memory cell structure is shown as comprising the transfer gate 101 and
a memory capacitor 103. A silicon substrate 105 is provided which is
oxidized to form the silicon oxide 107 underneath the gate polysilicon
109 for the gate transistor 101 and the silicon dioxide 109 underneath
the polysilicon 111 forming the capacitor 103. The source region 113
and drain region 115 are doped and the capacitor structure is capable
of forming the temporary junction 119 beneath the silicon oxide layer
109 in the silicon substrate 105, which junction is in electrical
connection with the drain doped region 115.

The equivalent circuit for the structure shown in FIG. 1 is shown
in FIG. 3 as comprising the transfer or gating transistor 101 and the
capacitor 103. However, the junction or inversion layer 119 beneath
capacitor 103 in the structure of FIG. 1 is only there when the positive
voltage is applied to the capacitor lead 121. In contrast the structure
of FIG. 2 provides a permanent junction 151 because the doped polysilicon I layer 153 is in direct contact with the surface of the
silicon substrate 155 and the dopant is diffused into the bulk silicon
to form a junction. This same layer of poly I, shown at 153 forms the
transfer gate polysilicon layer 159 over a thin layer of silicon oxide
161. The doped n+ region 163 is the source and the doped n+ region 165

- 5 -

is the drain which region is in electrical contact with the junction region 151.

The thin layer of nitride 169 forms the dielectric for the capacitance which structure is completed by the poly II layer 171. The ground lead 173 for poly II layer 171 enables the junction capacitor and the nitride capacitor to be connected in parallel, thereby considerably enhancing the capacitance obtained from the structure of FIG. 2.

The electrical circuit is shown in FIG. 4 where C2 is the combined capacitance of the junction and the nitride layer, but otherwise the circuit is the same as the memory cell circuit of FIG. 3 using transfer gate 201 for determining access to capacitor 203.

The mathematics applicable to the structure of FIG. 1 versus the mathematics applicable to the structure of FIG. 2 will bear out the improvement of the utilization of real estate by virtue of increased capacity obtainable from the present invention.

Considering first the structure of FIG. 1, which is evidenced by the circuitry of FIG. 3, it must be recalled that the terminal 121 of the capacitor must be held at a positive voltage to maintain the inversion under the capacitor. With this in mind, the total capacitance per unit area is given by $\varepsilon_{ov}/t_{ox} + C_D$. $\varepsilon_{ox}$ is the permittivity of the oxide 100, whereas $t_{ox}$ is the thickness of the oxide. $C_D$ is the depletion layer capacity. $\varepsilon_{ox}/t_{ox}$ is therefore $C_{ox}$. In the foregoing, $C_D$, the depletion layer capacitance is very small, and C is approximately equal to $C_1 = \varepsilon_{ox}/t_{ox} \times A$, where A is the area of the capacitor.

Now for purposes of comparison, the mathematics for the improved structure of FIG. 2 will be given. The total capacitance per unit area is given by $C_j + C_n$ where $C_j$ is the junction capacitance and $C_n$ is the nitride capacitance.

$C_n = \varepsilon_n/t_n$ for the nitride capacitor wherein $\varepsilon_n$ is about two times higher than $\varepsilon_{ox}$ and $t_n$ can usually be a thinner layer than that used for an oxide capacitor, therefore enhancing the value of $C_n$. $C_j$ is given by

$$\sqrt{QE_s N_b/2(V_{bi-} + V)} .$$ $C_2$ is therefore equal to $(C_j + C_n)$ x A where A is the capacitor. Notice that in comparing these equations, $C_n$ is much greater than $C_{ox}$ since $\varepsilon_n$ is greater than $\varepsilon_{ox}$ and $t_n$ is less than $t_{ox}$. By way of example, the $t_n$ equalling approximately 400 Å and $t_{ox}$ approximately 4 $C_{ox}$. In addition, the junction capacitance increases $C_2$ to a value equivalent to 6 $C_1$. Thus, the area of a memory cell capacitor can be reduced by a factor of 6 times without any decrease in storage capacitance. Furthermore, reduction in the cell area usually results in shorter column bit lines so that the ratio of the storage cell capacitance to bit line parasitic capacitance is increased, thereby providing a larger sense signal to the sense amplifier inputs. The decay rate of the storage charge in the cell is proportional to the area of the capacitor. Thus, by reducing the cell area, while maintaining the same charge storage, means a better retention time, and reduces the frequency of the refresh cycles. The top electrode, the second poly layer 171 of the storage capacitor is connected to the ground potential, as shown by lead 173. This arrangement provides better reliability than the conventional configuration where the top electrode 121 is connected to the most positive supply, usually $V_{dd}$, because of less severe DC supply and no field inversion problems.

It will now be appreciated that the present circuitry and method of attaining a high capacitance cell can be applied to any high density dynamic memory circuit.

The same principles obtain in the structure of FIG. 5 which merely shows a silicon on sapphire structure patterned after the structure on silicon of FIG. 2, thus the prime of the numbers applied to the structure of FIG. 2 will be used in FIG. 5. The sapphire substrate is shown at 211 and the silicon layer at 155'. The capacitor comprises the poly I layer 153', the thin nitride layer 169', the poly II layer 171' and the grounding lead 173'.

The transfer transistor gate comprises a silicon oxide layer 161', the source 163' and the drain 165' with the capacitor junction 151' being located beneath the poly I layer 153'. Otherwise, the principles of operation heretofore explained obtain in the structure of FIG. 5.

Many existing processes will provide manufacturing methods for the present invention provided they are modified to develop the capacitive structure in conjunction with the transfer transistor gate structure. One method is illustrated in FIGs. 7 through 23 wherein a substrate 501 of for example P(100) type silicon single or monocrystalline structure has grown thereon a thin silicon oxide layer 503, in turn covered by a nitride layer 505 and, as shown in FIG. 7 photoresist 507 defined by the active mask 509 shown in the solid outline in FIG. 6. The silicon oxide coating 503 is quite thin of the order of 100 $\overset{o}{A}$ with the silicon nitride coating 505 being of the order of 1000 $\overset{o}{A}$. The resist used in layer 507 may be AZ 1350J or HPR204 or equivalent.

With the active area being defined by the solid line mask 509, in FIG. 8, the field implant is shown by the xs identified at 511, the unprotected nitride 505 and silicon oxide 503 having been removed by appropriate etching techniques, boron or the like is used here to provide a heavily doped P region surrounding the active area of a device with n+ source and drains.

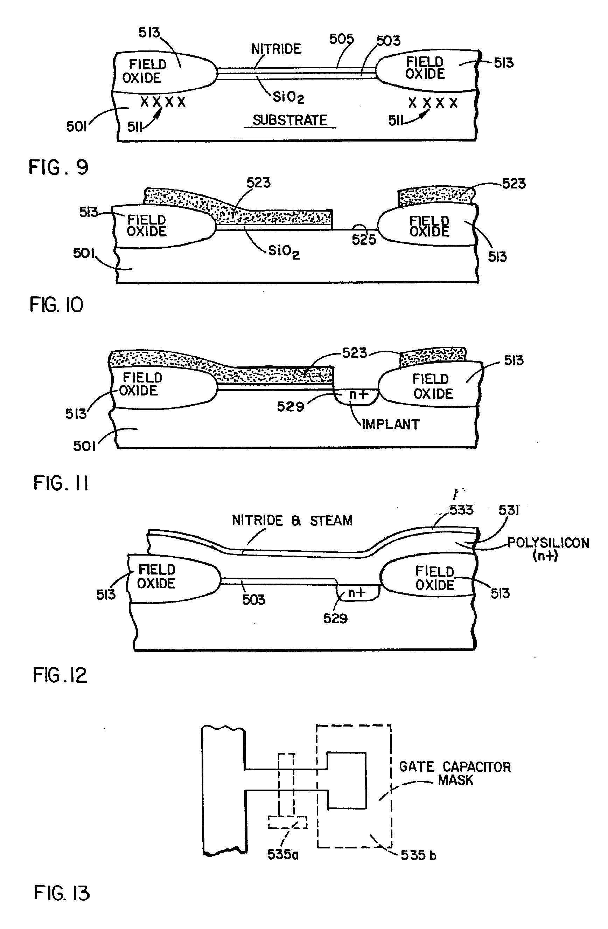

In FIG. 9, the resist 507 has been removed and the field oxide grown at 513 which encircles the active region. The field oxide 513 may have a thickness of the order of 18.6 K angstroms.

FIGURE 10 shows the outline of the capacitor region utilizing the capacitor mask -1 shown dotted at 521 in FIG. 6. First, the entire region is covered by the photoresist 523 and thereafter the mask 521 is utilized to open the region 525 to the bare silicon substrate using conventional processing techniques.

In FIG. 11 the n+ implanting of the region within substrate 501 below bare silicon surface 525 is accomplished by ion implant or the like. Note that in FIGs. 9 and 10, the nitride layer 505 has been etched away and the photoresist 523 applied directly to the silicon oxide layer.

In FIG. 11, the implanting is preferably carried out by a high energy ion implant. And the n+ region is indicated at 529.

In FIG. 12, a layer of n+ doped polysilicon 531 is applied over the entire active area and is covered with a thin layer of nitride 533. The device is subjected to high temperature to drive the dopant in to increase the depth of the region 529.

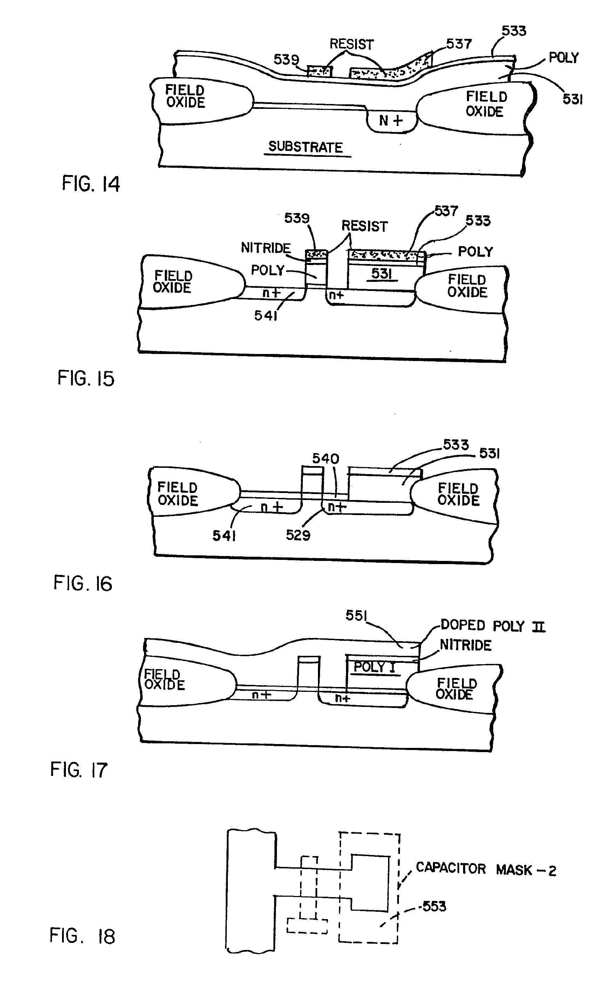

Next, the gate capacitor mask, consisting of dotted parts 535a and 535b in FIG. 13 is utilized to provide a resist pattern in accordance with FIG. 14 wherein the resist 537 defines the capacitive region and the resist 539, the gate region.

In FIG. 15, the nitride and doped polysilicon layers 533 and 531 have been etched away where unprotected by the resist 537 and 539. Also, the region to the left of the gate region covered by resist 539 is implanted (or diffused) by n+ material in the area illustrated at 541 for the source region of the transistor being formed.

In FIG. 16, the resist has been removed at 537 and 539 (FIG. 15) and a thin layer of oxide 540 grown over n+ region 529.

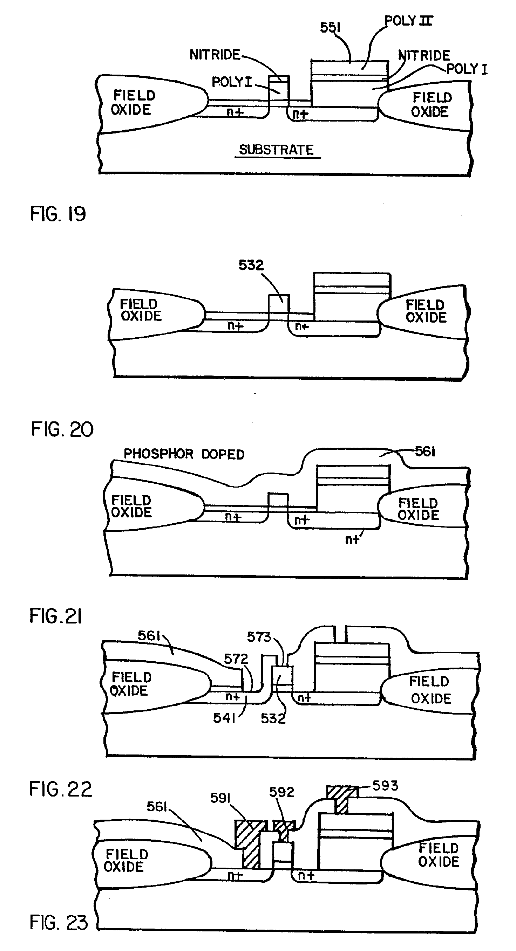

In FIG. 17, a layer of doped poly II silicon 551 is applied over the entire active area. FIGURE 18 shows the capacitor mask -2, shown dotted at 553 which is used to lay down a resist pattern shown in FIG. 19 wherein the poly II 551 which is preserved will comprise the outer plate of the capacitor structure being formed.

In FIG. 20, the nitride has been removed from the gate polysilicon layer 532 and in FIG. 21 the entire structure has been covered by a layer of phosphorus doped glass 561. The purpose of the glass is to form a high resistivity layer over the components to isolate them when terminal connections are provided.

In FIG. 22, it may be seen that an opening has been made to the n+ source region 541 as represented at 572. Also, an opening 573 has been made to the top of the polysilicon 532 comprising a gate. Finally, an opening has been made to the polysilicon 551 comprising the capacitor and is shown at 574.

These openings are filled by a metal to provide the source
conductor shown at 591 in FIG. 23, the gate conductor 592, and the
capacitance conductor 593. The latter may simply be grounded to
provide the capacitive addition.

In order to form the openings described in FIG. 22, a standard
opening technique is applied where masking is used to protect the
remaining surface while allowing etching to take place in the areas
to be opened.

While the principles of a silicon manufacturing process have
been illustrated, nevertheless many of the steps may be rearranged
time wise  and, accordingly, it is desired that the invention only be
defined by the scope of the claims attached hereto.

78E34                              - 10 -

The invention may be summarized as follows:

1.  A high capacitance memory cell comprising in combination;

a bulk silicon wafer;

a doped polysilicon layer adjacent a surface of the
silicon wafer for forming a junction therein;

a patterned nitride layer adjacent the doped polysilicon
layer;

a polysilicon layer adjacent the nitride layer; and,

means for establishing electrical connection across the
nitride layer.

2.  The high capacitance memory cell of  item1, further comprising;

a field effect transistor comprising a silicon oxide layer
adjacent said surface of the silicon wafer;

a polysilicon layer adjacent said silicon oxide layer;

doped regions in the silicon wafer beneath opposite sides of
the silicon oxide-polysilicon layers of which one region is formed by
said doped polysilicon; and,

means for establishing electrical connection to the doped
region not formed by the doped polysilicon and to said polysilicon
layer adjacent said silicon oxide layer.

- 11 -

3. A plurality of VLSI capacitors, each comprising in combination;

a tiny portion of a bulk silicon wafer;

a doped polysilicon layer portion adjacent a surface of the silicon wafer for forming an n+ junction therein;

a patterned nitride layer portion adjacent the doped polysilicon layer;

a polysilicon layer portion adjacent the nitride layer; and,

means for establishing electrical connection across the nitride layer.

4. In combination with each of the capacitors of item 3, a high density type field effect transistor comprising in combination;

a silicon oxide layer portion on said wafer spaced from the capacitor;

a polysilicon layer portion on said silicon oxide layer portion for forming a gate electrode;

a doped region within the wafer in electrical connection with said junction and extending for the length of the spacing between the silicon oxide layer and the respectively related capacitor to form a drain region;

a further doped region within the wafer on the opposite side of the silicon oxide layer from the first mentioned doped region to comprise a source; and,

means for establishing electrical connection to the source and gate electrode.

5. A VLSI capacitor comprising in combination;

a sapphire substrate;

a silicon layer thereon;

a polysilicon layer adjacent the silicon layer for doping the silicon to form a junction therein;

a nitride layer adjacent the polysilicon layer;

a second polysilicon layer adjacent the nitride layer; and,

means for establishing electrical connection across the nitride layer.

6.  In combination with the capacitor of item 4, a high density type field effect transistor comprising in combination;

a silicon oxide layer on said substrate spaced from the capacitor;

a polysilicon layer on said silicon oxide layer for forming a gate electrode;

a doped region within the silicon layer in electrical connection with said junction and extending for the length of the spacing between the silicon oxide layer and the capacitor to form a drain region;

a further doped region within the silicon layer on the opposite side of the silicon oxide layer from the first mentioned doped region to comprise a source; and,

means for establishing electrical connection to the source and gate electrode.

7. The method of making minimal area high capacitance memory cells on a semiconductor substrate to very large scale integrated circuit dimensions with each cell having a capacitor and a transistor, comprising the steps of:

outlining active areas on the substrate by field oxide;

growing gate oxides within said areas;

forming openings through the gate oxides to the substrate for the capacitors;

doping isolated regions of the substrate via said openings;

forming a layer of doped polysilicon covered by a layer of nitride over said doped regions as a portion of a capacitor structure and at spaced locations relative thereto over the gate oxides as associated gates therefor;

removing the gate oxide around each gate and between the gate and associated capacitor structure;

driving dopant into the substrate through the removed gate oxide areas, which dopant on the side of the capacitor structure connects with the doped regions thereunder;

forming layers of doped polysilicon over the nitride layers of the capacitor structures; and,

providing electrical connections to the doped substrate adjacent the gates away from the capacitors, to the gate polysilicon layers, and to the capacitor layers of doped polysilicon over their nitride layers.

8. The method of item 7, wherein:

said outlining active areas comprises growing an oxide coating on the substrate;

depositing nitride over the oxide coating;

masking the active areas on the nitride;

exposing the unmasked nitride to actinic radiation; and,

developing the exposed nitride to remove the same.

9. The method of making minimal area high capacitance memory cells on a silicon substrate to very large scale integrated circuit dimensions with each cell including a capacitor and a FET, comprising the steps of:

outlining active areas for an associated capacitor and FET on the substrate by field oxide;

growing gate oxides for the FETs within said areas;

forming openings through the gate oxides to the substrate for the capacitors;

doping isolated regions of the substrate via said openings;

forming a layer of doped polysilicon covered by a layer of nitride at least over said doped regions as a portion of a capacitor structure and at spaced locations relative thereto over the gate oxides as associated gates therefor;

removing the gate oxide around each gate and between the gate and the associated capacitor structure;

driving dopant into the substrate through the areas of the substrate from which the gate oxide has been removed to define further doped regions of which one further region on the side of the capacitor structure connects with the doped regions thereunder;

forming layers of doped polysilicon over the nitride layers of the capacitor structures;

covering the active regions with phosphorus doped glass; and

establishing electrical connection to the doped substrate adjacent the gates away from the capacitors, to the gate polysilicon layers, and to the capacitor layers of doped polysilicon over their nitride layers.

10. The method of item 9, wherein:

the electrical connection is established by opening a hole through the phosphorus doped glass to said last mentioned doped substrate, to the gate polysilicon layer and to the doped polysilicon layer over the nitride layer for the capacitors, all in spaced apart relation for receiving electrically isolated conductors.

11.  The method of making minimal area high capacitance memory cells having a single transistor including a gate and a capacitance structure on a semiconductor substrate, comprising the steps of:

forming each gate as a layer of gate oxide on said substrate with a layer of doped polysilicon thereover and electrical connection in contact with the polysilicon;

forming doped substrate regions on opposite sides of the gate to comprise said transistor;

forming a further doped region in the substrate in electrical connection with a doped region on one side of the gate;

forming electrical connection with the substrate doped region on the other side of said gate; and,

forming the capacitance structure over the further doped region as a layer of doped polysilicon on the substrate, covered by a layer of nitride, in turn covered by a second layer of doped polysilicon with electrical connection to the latter.

12.  The method of item 11, wherein:

said semiconductor is P type silicon; and
said first mentioned doped polysilicon is n+ doped.

13.  The method of item 12, wherein:

the doped substrate regions on opposite sides of said gate are n+ doped.

14.  The method of item 13, wherein:

said last mentioned layer of polysilicon is doped n+.

15.  The method of making minimal area high capacitance memory cells comprising a capacitor and a transistor on a P doped silicon substrate, comprising the steps of:

growing an oxide coating on the silicon substrate;

depositing nitride over the oxide;

applying resist over the nitride;

masking active areas on the resist;

removing the resist, nitride and oxide from the unmasked regions;

implanting P doping material in the uncovered regions;

oxidizing the substrate in the uncovered regions to form the field oxide;

.applying resist to the oxidized substrate;

masking the resist to outline an opening to the substrate for the capacitor structure;

developing the resist to form said opening;

implanting n+ doping material into the substrate via said opening;

applying a layer of n+ doped polysilicon over the oxide on the silicon substrate, over the n+ doped region of the substrate, and over at least part of the field oxide;

applying a thin nitride layer over the doped polysilicon;

steaming the nitride layer to drive the dopant;

applying resist over the nitride;

masking the resist to outline a gate associated with a capacitive structure at least for each active area;

exposing and developing the resist to leave spaced apart gate and capacitive resist areas;

removing the nitride, polysilicon and oxide from the substrate where not covered by resist;

doping n+ the substrate region on opposite sides of the gate with said doping establishing electrical connection on the side of the capacitance structure with the n+ doping material implanted via said opening;

item 15 continued

        growing a thin oxide layer on the exposed substrate;

        removing the resist from the gate and capacitance
structure;

        covering the active area with doped polysilicon;

        masking said n+ doped polysilicon to define the remainder
of the capacitance structure;

        removing the last mentioned n+ doped polysilicon except
from the capacitor;

        removing the nitride from the gate;

        covering the active region with phosphorus doped glass;
and,

        establishing electrical connections to the n+ doped region
adjacent the gate but away from the capacitance structure, to the gate
polysilicon, and to the capacitor last mentioned n+ doped polysilicon.

Claims:

1.  A high capacitance memory cell comprising in combination;

a bulk silicon wafer;

a doped polysilicon layer adjacent a surface of the silicon wafer for forming a junction therein;

a patterned nitride layer adjacent the doped polysilicon layer;

a polysilicon layer adjacent the nitride layer; and,

means for establishing electrical connection across the nitride layer.

2.  The high capacitance memory cell of Claim 1, further comprising;

a field effect transistor comprising a silicon oxide layer adjacent said surface of the silicon wafer;

a polysilicon layer adjacent said silicon oxide layer;

· doped regions in the silicon wafer beneath opposite sides of the silicon oxide-polysilicon layers of which one region is formed by said doped polysilicon; and,

means for establishing electrical connection to the doped region not formed by the doped polysilicon and to said polysilicon layer adjacent said silicon oxide layer.

3. A plurality of VLSI capacitors, each comprising in combination;

a tiny portion of a bulk silicon wafer;

a doped polysilicon layer portion adjacent a surface of the silicon wafer for forming an n+ junction therein;

a patterned nitride layer portion adjacent the doped polysilicon layer;

a polysilicon layer portion adjacent the nitride layer; and,

means for establishing electrical connection across the nitride layer.


4. In combination with each of the capacitors of Claim 3, a high density type field effect transistor comprising in combination;

a silicon oxide layer portion on said wafer spaced from the capacitor;

a polysilicon layer portion on said silicon oxide layer portion for forming a gate electrode;

a doped region within the wafer in electrical connection with said junction and extending for the length of the spacing between the silicon oxide layer and the respectively related capacitor to form a drain region;

a further doped region within the wafer on the opposite side of the silicon oxide layer from the first mentioned doped region to comprise a source; and,

means for establishing electrical connection to the source and gate electrode.


5. A VLSI capacitor comprising in combination;

a sapphire substrate;

a silicon layer thereon;

a polysilicon layer adjacent the silicon layer for doping the silicon to form a junction therein;

a nitride layer adjacent the polysilicon layer;

a second polysilicon layer adjacent the nitride layer; and,

means for establishing electrical connection across the nitride layer.

- 20 -

6. In combination with the capacitor of Claim 4, a high density type field effect transistor comprising in combination;

a silicon oxide layer on said substrate spaced from the capacitor;

a polysilicon layer on said silicon oxide layer for forming a gate electrode;

a doped region within the silicon layer in electrical connection with said junction and extending for the length of the spacing between the silicon oxide layer and the capacitor to form a drain region;

a further doped region within the silicon layer on the opposite side of the silicon oxide layer from the first mentioned doped region to comprise a source; and,

means for establishing electrical connection to the source and gate electrode.

7. The method of making minimal area high capacitance memory cells on a semiconductor substrate to very large scale integrated circuit dimensions with each cell having a capacitor and a transistor, comprising the steps of:

outlining active areas on the substrate by field oxide;

growing gate oxides within said areas;

forming openings through the gate oxides to the substrate for the capacitors;

doping isolated regions of the substrate via said openings;

forming a layer of doped polysilicon covered by a layer of nitride over said doped regions as a portion of a capacitor structure and at spaced locations relative thereto over the gate oxides as associated gates therefor;

removing the gate oxide around each gate and between the gate and associated capacitor structure;

driving dopant into the substrate through the removed gate oxide areas, which dopant on the side of the capacitor structure connects with the doped regions thereunder;

forming layers of doped polysilicon over the nitride layers of the capacitor structures; and,

providing electrical connections to the doped substrate adjacent the gates away from the capacitors, to the gate polysilicon layers, and to the capacitor layers of doped polysilicon over their nitride layers.

8. The method of Claim 7, wherein:

said outlining active areas comprises growing an oxide coating on the substrate;

depositing nitride over the oxide coating;

masking the active areas on the nitride;

exposing the unmasked nitride to actinic radiation; and,

developing the exposed nitride to remove the same.

9. The method of making minimal area high capacitance memory cells on a silicon substrate to very large scale integrated circuit dimensions with each cell including a capacitor and a FET, comprising the steps of:

outlining active areas for an associated capacitor and FET on the substrate by field oxide;

growing gate oxides for the FETs within said areas;

forming openings through the gate oxides to the substrate for the capacitors;

doping isolated regions of the substrate via said openings;

forming a layer of doped polysilicon covered by a layer of nitride at least over said doped regions as a portion of a capacitor structure and at spaced locations relative thereto over the gate oxides as associated gates therefor;

removing the gate oxide around each gate and between the gate and the associated capacitor structure;

driving dopant into the substrate through the areas of the substrate from which the gate oxide has been removed to define further doped regions of which one further region on the side of the capacitor structure connects with the doped regions thereunder;

forming layers of doped polysilicon over the nitride layers of the capacitor structures;

covering the active regions with phosphorus doped glass; and

establishing electrical connection to the doped substrate adjacent the gates away from the capacitors, to the gate polysilicon layers, and to the capacitor layers of doped polysilicon over their nitride layers.

10. The method of Claim 9, wherein:

the electrical connection is established by opening a hole through the phosphorus doped glass to said last mentioned doped substrate, to the gate polysilicon layer and to the doped polysilicon layer over the nitride layer for the capacitors, all in spaced apart relation for receiving electrically isolated conductors.

FIG. 1 PRIOR ART

POLY I · 109
101 SiO₂
121
103
POLY I · 111
SiO₂ · 106
n+ · 113
107
n+ · 115
119
105

FIG. 2

POLY I · 159
SiO₂
169
173
POLY II · 171
NITRIDE
POLY I · 153
N · 163
161
n+ · 165
151
155

FIG. 3 PRIOR ART

101
C₁ · 103
V_DD

FIG.4

201
203 → C₂
V_DD

FIG.5

POLY I
SiO₂ · 169'
169'
173'
171'
POLY II
NITRIDE
POLY I
153'
n+ · 163'
161'
n+ · 165'
151'
SILICON
SAPPHIRE
211

FIG.6

509
ACTIVE REGION MASK
521
CAPACITOR MASK-1

FIG. 7

507
PHOTO RESIST
505
NITRIDE
503
SiO₂
P⟨100⟩
501
SUBSTRATE
SILICON

FIG.8

507
PHOTO RESIST
505
503
NITRIDE
501
X X X X
511
SiO₂
X X X X
511

513

FIELD OXIDE

NITRIDE  505  503

FIELD OXIDE — 513

SiO₂

X X X X

501  511

X X X X

511

SUBSTRATE

**FIG. 9**

523

513  FIELD OXIDE

523

FIELD OXIDE

SiO₂

501

525

513

**FIG. 10**

523

FIELD OXIDE

513

FIELD OXIDE

529  n+

513

501

IMPLANT

**FIG. 11**

NITRIDE & STEAM

533  531

POLYSILICON (n+)

FIELD OXIDE

513

FIELD OXIDE

513

503

529

n+

**FIG. 12**

GATE CAPACITOR MASK

535a

535 b

**FIG. 13**

3/4

0053654

FIG. 14

FIG. 15

FIG. 16

FIG. 17

FIG. 18

4/4

FIG. 19

FIG. 20

FIG. 21

FIG.22

FIG. 23